# DEMANDE DE BREVET EUROPEEN

(11) **EP 4 378 594 A1**
(43) Date de publication de la demande: **05.06.2024**
(21) Numéro de dépôt: 22210400.2
(22) Date de dépôt: 29.11.2022
(51) Int. Cl.: B05D 1/00, B05D 5/00, C08J 7/04, C08J 7/12, H01J 37/32, H05H 1/00, C23C 16/513, C23C 16/02, F21S 41/26, F21S 41/20, F21S 45/10, G02B 1/10, C23C 16/503

(54) **GLACE DE FERMETURE D'UN DISPOSITIF LUMINEUX POUR VÉHICULE**

(71) Demandeur: Valeo Vision, 93012 Bobigny Cedex (FR)
(72) Inventeur: BRASSIER, Marc, 93012 BOBIGNY (FR); REVOL, Damien, 93012 BOBIGNY (FR)
(74) Mandataire: Valeo Visibility

(57) **Abrégé**

La présente invention concerne une glace de fermeture (4) d'un dispositif lumineux (2) pour véhicule (1) comprenant au moins une première couche transparente (6) en un matériau polymère, caractérisée en ce que la glace de fermeture (4) comprend au moins une deuxième couche transparente (8) et une troisième couche transparente (10) formées par traitement d'au moins un composant précurseur (CP), les couches étant réalisées en recouvrement les unes des autres, le traitement d'au moins l'une des deuxième couche transparente (8) et/ou troisième couche transparente (10) étant assistée par plasma atmosphérique à torche plasma.

## Description

La présente invention se rapporte au domaine des revêtements fonctionnels de module optique pour véhicule automobile. Plus précisément, l'invention a trait à une glace de fermeture d'un dispositif lumineux pour véhicule, notamment automobile, comprenant un substrat sur lequel une couche est déposée par plasma atmosphérique à décharge à barrière diélectrique volumique.

Les glaces de fermeture sont généralement disposées en fermeture d'un boîtier de projecteur d'un véhicule automobile, au sein duquel sont disposés un ou plusieurs modules lumineux, ces derniers ayant par exemple pour fonction d'éclairer l'environnement extérieur du véhicule ou de signaler le véhicule lumineux aux autres usagers de la route. Chaque module lumineux comprend classiquement un dispositif lumineux générant des rayons lumineux, un système de guidage desdits rayons lumineux vers l'extérieur du module d'éclairage et une lentille agencée en travers des rayons lumineux pour former un faisceau lumineux dirigé vers l'extérieur du boîtier de projecteur dans lequel le module lumineux est logé. Une glace de fermeture est disposée en fermeture du boîtier de projecteur pour éviter que des salissures ou des projections d'eau par exemple ne pénètrent dans le boîtier de projecteur et viennent au contact des modules lumineux. Cette glace de fermeture est translucide ou transparente et elle est optiquement neutre, c'est-à-dire que les faisceaux lumineux formés en sortie des modules lumineux traversent la glace de fermeture sans subir de déformations sensibles.

Ces glaces de fermetures sont exposées à l'environnement extérieur du véhicule et elles peuvent présenter à cet effet plusieurs propriétés répondant à la demande des utilisateurs ou des fabricants de véhicules. Ainsi, la glace de fermeture peut posséder, par exemple, des propriétés antibuée, des propriétés anti-abrasion, des propriétés anti-reflet et/ou des propriétés auto-réparatrices. La glace de fermeture peut également posséder, par exemple, en plus, des propriétés autorisant le passage d'ondes électromagnétiques depuis l'intérieur du module d'éclairage vers l'extérieur de ce dernier tout en bloquant le passage d'ondes électromagnétiques à certaines longueurs d'onde depuis l'extérieur du module d'éclairage vers l'intérieur de ce dernier. Ces propriétés sont notamment obtenues par l'intermédiaire d'au moins une couche d'un revêtement déposé sur un substrat formant la structure de la glace de fermeture.

L'obtention de ces couches apportant des propriétés avantageuses aux glaces de fermeture reste cependant complexe, notamment sur des surfaces aussi importantes que celles des glaces de fermeture complexifiant la réalisation industrielle desdites glaces de fermeture. De plus, une fois ces couches réalisées, elles forment un vernis avec une épaisseur importante, pouvant dégrader le design du produit formé.

Dans le présent contexte, on comprend que les procédés de dépôt connus ne permettent plus de répondre au besoin des clients. La présente invention propose une alternative à ce problème et concerne ainsi une glace de fermeture dont une couche est réalisée de sorte à optimiser son dépôt sur une surface aussi importante qu'une glace de fermeture et dont le produit, une fois réalisé, propose un design apte à répondre aux attentes des clients.

La présente invention a pour principal objet une glace de fermeture d'un dispositif lumineux pour véhicule comprenant au moins une première couche transparente en un matériau polymère, caractérisée en ce que la glace de fermeture comprend au moins une deuxième couche transparente et une troisième couche transparente formées par traitement d'au moins un composant précurseur, les couches étant réalisées en recouvrement les unes des autres, le traitement d'au moins l'une des deuxième couche transparente et/ou troisième couche transparente étant assistée par plasma atmosphérique à torche plasma.

Il faut entendre ici, ainsi que dans tout ce qui suit, par « glace de fermeture » ou par « couche transparente », un élément ou une couche transmettant au moins un rayonnement électromagnétique, par exemple de la lumière visible ou une onde radar, par réfraction et au travers duquel/de laquelle les objets sont visibles avec plus ou moins de netteté, par exemple, par un détecteur de rayonnement électromagnétique avec très peu voire sans dispersion. De préférence, la transmission du rayonnement électromagnétique, à travers la glace de fermeture transparent est d'au moins 87%. La transmission du rayonnement électromagnétique est la quantité de rayonnement électromagnétique que laisse passer la glace de fermeture transparent ou couche transparente à partir d'un rayonnement électromagnétique indicent.

La glace de fermeture de l'invention peut être du type vitrage automobile, et peut faire partie par exemple d'un dispositif lumineux tel qu'un projecteur avant, un feu arrière ou encore un système d'éclairage intérieur.

La glace de fermeture de l'invention peut également consister en une glace associée à un système de détection, qui peut par exemple être un dispositif radar ou un dispositif lidar. Le dispositif radar est configuré pour émettre des ondes radar. Le dispositif lidar est configuré pour émettre de la lumière du spectre visible, infrarouge ou ultraviolet, la lumière étant issue d'un laser.

Le traitement de l'une et/ou l'autre des deuxième et/ou troisième couche transparentes par plasma atmosphérique à torche plasma est réalisé par la formation d'un plasma à partir d'au moins un précurseur sous forme gazeuse disposé entre une électrode et une contre-électrode.

Plus précisément, la contre-électrode est par exemple formé par une bobine électromagnétique prenant la forme d'un conduit au centre duquel s'étend l'électrode, le précurseur sous forme gazeuse et avantageusement compressé s'étendant dans le conduit formé par la bobine électromagnétique autour de l'électrode. De l'air provenant de l'environnement extérieur à la torche plasma est également mélangé au précurseur sous forme gazeuse et avantageusement compressé. Une décharge électrique entre l'électrode et la contre électrode entraîne la formation de plasma à partir du mélange d'air et du précurseur, ce plasma étant ensuite projeté contre la glace de fermeture pour réaliser la deuxième couche transparente et/ou la troisième couche transparente.

Une couche transparente réalisée par plasma atmosphérique à torche plasma est une solution astucieuse en permettant de réaliser, en peu de temps et à bas coût, sur une surface aussi importante qu'une glace de fermeture, une couche transparente optiquement neutre et apportant une propriété additionnelle à la glace de fermeture, comme une propriété antibuée ou une propriété anti-rayure. De plus, les composants précurseurs utilisés pour réaliser ces couches transparentes peuvent être rapidement changés et/ou utilisés en combinaison avec d'autres composants précurseurs.

On comprend également de ce qui précède que la deuxième couche transparente ou la troisième couche transparente est disposée sur une face extérieure de la première couche transparente, c'est-à-dire vers l'environnement extérieur de la glace de fermeture. Les couches transparentes de la glace de fermeture sont ainsi agencées de sorte qu'une des couches transparentes soit disposée entre l'autre couche transparente et la première couche transparente.

Dans cette disposition, la deuxième couche transparente et la troisième couche transparente sont aptes à diminuer la dégradation des différents composants du dispositif lumineux, en bloquant par exemple le passage d'ondes électromagnétique présentant une longueur d'onde ciblée.

Selon une caractéristique optionnelle de l'invention, la deuxième couche transparente présente une épaisseur d'au plus vingt nanomètres.

Avantageusement, la deuxième couche transparente présente une épaisseur comprise entre cinq et quinze nanomètres.

Encore plus avantageusement, la deuxième couche transparente présente une épaisseur de dix nanomètres.

Selon une autre caractéristique optionnelle de l'invention, la deuxième couche transparente est une couche hydrophile.

Selon une autre caractéristique optionnelle de l'invention, la deuxième couche transparente est une couche hydrophobe.

Selon une autre caractéristique optionnelle de l'invention, la deuxième couche transparente est une couche anti-corrosion.

Selon une autre caractéristique optionnelle de l'invention, la deuxième couche transparente est directement en contact physique avec la première couche.

Selon une autre caractéristique optionnelle de l'invention, la deuxième couche transparente est directement en contact physique avec la troisième couche transparente.

Selon une autre caractéristique optionnelle de l'invention, le composant précurseur se présente sous forme liquide, et/ou est dissous dans un solvant, et/ou est dilué dans solvant.

Selon une autre caractéristique optionnelle de l'invention, le traitement de la troisième couche transparente est une polymérisation de l'au moins un composant précurseur assistée par plasma atmosphérique à décharge à barrière diélectrique volumique.

Selon un mode de réalisation, la décharge à barrière diélectrique volumique est une décharge électrique silencieuse ou une décharge lumineuse homogène.

Un plasma atmosphérique à décharge à barrière diélectrique volumique aussi appelé « Dielectric Barrier Diffusion atmospheric plasma » en anglais est un type de plasma dont l'énergie est comprise entre l'énergie de dépôt chimique en phase vapeur assisté par plasma l'énergie et d'un plasma d'arc. Ainsi, un plasma atmosphérique à décharge à barrière diélectrique volumique permet de polymériser un ou plusieurs monomères organiques afin d'obtenir un polymère organique présentant un degré de polymérisation voulu. En outre un plasma atmosphérique à décharge à barrière diélectrique volumique permet de réticuler le polymère en présence ou non d'au moins un agent de réticulation pour obtenir un degré de réticulation désiré. Par conséquent, il est aisé de contrôler les propriétés du polymère ainsi obtenu et donc les propriétés de la glace de fermeture.

Il résulte de ce qui précède que selon cette dernière caractéristique, la deuxième couche transparente est réalisée par plasma atmosphérique à torche plasma tandis que la troisième couche transparente est réalisée par plasma atmosphérique à décharge à barrière diélectrique volumique.

Selon une autre caractéristique optionnelle de l'invention, la deuxième couche transparente est disposée entre la première couche et la troisième couche transparente. Autrement dit, la deuxième couche transparente est en contact direct avec la première couche d'une part et la troisième couche transparente d'autre part. Un tel agencement est notamment intéressant dans la configuration précédemment évoquée où la deuxième couche transparente est réalisée par plasma atmosphérique à torche plasma et où la troisième couche transparente est réalisée par plasma atmosphérique à décharge à barrière diélectrique volumique. On peut ainsi cibler l'application de la technique à barrière diélectrique volumique, grâce à laquelle il est plus facile de contrôler les propriétés du polymère ainsi obtenu et donc les propriétés de la glace de fermeture, à une couche destinée à être en surface tournée vers l'extérieur du véhicule et donc destinée à être visible par les observateurs extérieurs.

Selon une autre caractéristique optionnelle de l'invention, la deuxième couche transparente comprend plusieurs sous-couches en recouvrement les unes des autres formées par traitement d'au moins un composant précurseur par plasma atmosphérique à torche plasma, la troisième couche transparente comprenant plusieurs sous-couches en recouvrement les unes des autres formées par traitement d'au moins un composant précurseur par plasma atmosphérique à décharge à barrière diélectrique volumique.

Selon une autre caractéristique optionnelle de l'invention, la glace de fermeture comprend une couche préalable formée au moins par un composant couplé à de l'argon, la couche préalable étant disposée entre la première couche et la deuxième couche transparente en étant réalisée par plasma atmosphérique à torche plasma ou à décharge à barrière diélectrique volumique.

Selon une autre caractéristique optionnelle de l'invention, la glace de fermeture comprend une couche externe formée au moins par un précurseur additionnel, la troisième couche transparente étant disposée entre la deuxième couche transparente et la couche externe, la couche externe étant réalisée par plasma atmosphérique à décharge à barrière diélectrique volumique.

Selon une autre caractéristique optionnelle de l'invention, le composant précurseur est choisi parmi un monomère organique, un monomère organométallique, un prépolymère organique et un de leurs mélanges.

Selon une autre caractéristique optionnelle de l'invention, le matériau polymère de la première couche transparente comprend au moins un polymère choisi parmi le polycarbonate (PC), le polycarbonate modifié haute température (PC-HT), le polyméthacrylate de méthyle (PMMA), le poly metacryl méthyl imide (PMMI), le cyclo olefine polymer (COP), le cyclo olefine copolymer (COC), le polysulfone (PSU), le polyarylate (PAR), le polyamide (PA), et un de leurs mélanges.

L'invention a également pour objet un procédé de traitement d'une glace de fermeture transparente comprenant une première étape de traitement au cours de laquelle la deuxième couche transparente est formée sur la première couche et au moins une deuxième étape de traitement au cours de laquelle la troisième couche transparente est réalisée sur la deuxième couche transparente, au moins l'une des étapes de traitement étant réalisée par plasma atmosphérique à torche plasma.

Selon une autre caractéristique optionnelle de l'invention, au cours de la première étape de traitement, la deuxième couche transparente est réalisée par plasma atmosphérique à torche plasma tandis que, au cours de la deuxième étape de traitement, la troisième couche transparente est réalisée par plasma atmosphérique à décharge à barrière diélectrique volumique.

Selon une autre caractéristique optionnelle de l'invention, le procédé de traitement d'une glace de fermeture comprend une étape préalable à l'une ou l'autre des étapes de traitement au cours de laquelle un composant couplé à de l'argon est déposée sur la première couche en étant réalisée par plasma atmosphérique à torche plasma ou à décharge à barrière diélectrique volumique.

Selon une autre caractéristique optionnelle de l'invention, le procédé de traitement d'une glace de fermeture comprend une étape de protection de la glace de fermeture au cours de laquelle une couche externe est réalisée par un précurseur additionnel par plasma atmosphérique à décharge à barrière diélectrique volumique.

D'autres caractéristiques, détails et avantages de l'invention ressortiront plus clairement à la lecture de la description qui suit d'une part, et de plusieurs exemples de réalisation donnés à titre indicatif et non limitatif en référence aux dessins schématiques annexés d'autre part, sur lesquels :
[Fig. 1] est une représentation schématique d'un véhicule comprenant un dispositif lumineux comportant une glace de fermeture selon l'invention ;
[Fig. 2] est une coupe transversale de la glace de fermeture représentée sur la figure 1 ;
[Fig. 3] est une représentation schématique d'une configuration d'un dispositif de dépôt d'une deuxième couche transparente et/ou d'une troisième couche transparente de la glace de fermeture représentée sur la figure 1.

Les caractéristiques, variantes et les différentes formes de réalisation de l'invention peuvent être associées les unes avec les autres, selon diverses combinaisons, dans la mesure où elles ne sont pas incompatibles ou exclusives les unes par rapport aux autres. On pourra notamment imaginer des variantes de l'invention ne comprenant qu'une sélection de caractéristiques décrites par la suite de manière isolée des autres caractéristiques décrites, si cette sélection de caractéristiques est suffisante pour conférer un avantage technique et/ou pour différencier l'invention par rapport à l'état de la technique antérieur.

Sur les figures, les éléments communs à plusieurs figures conservent la même référence.

Pour rappel, la présente invention concerne une glace de fermeture d'un dispositif lumineux remarquable en ce qu'il comprend une deuxième couche transparente et une troisième couche transparente déposées sur une première couche transparente en un matériau polymère, le deuxième couche transparente et/ou la troisième couche transparente étant obtenue par le traitement d'au moins un composant précurseur, le traitement étant assistée par plasma atmosphérique à torche plasma.

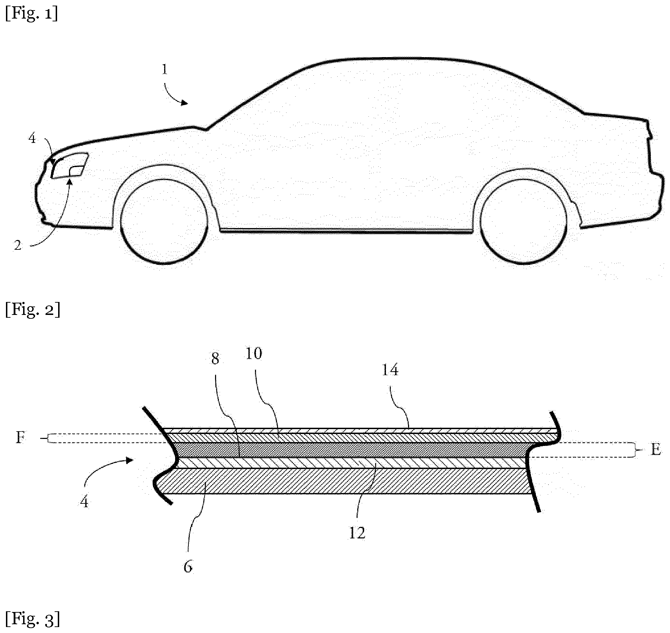

Sur la figure 1 est illustré un véhicule 1 automobile comprenant à l'avant un dispositif lumineux 2 comprenant une glace de fermeture 4 conforme à l'invention. Le dispositif lumineux 2 prend ici la forme d'un projecteur avant comportant en son sein au moins un module d'éclairage de l'environnement extérieur du véhicule 1 ou un module de signalisation du véhicule, mais il peut également prendre la forme d'un feu arrière du véhicule ou d'un indicateur de direction sans pour autant sortir du cadre de l'invention.

Selon l'invention, la glace de fermeture 4 comprend plusieurs couches réalisées en recouvrement les unes des autres, ces couches étant notamment visibles sur la figure 2 qui est une coupe transversale de la glace de fermeture 4, c'est-à-dire une coupe dans l'épaisseur, perpendiculairement à son plan d'allongement principal. Il est visible que la glace de fermeture 4 comprend, depuis l'intérieur du dispositif lumineux 2 vers l'extérieur de ce dernier, une première couche transparente 6, qui est avantageusement en un matériau polymère, une deuxième couche transparente 8 et au moins une troisième couche transparente 10, la deuxième couche transparente 8 et la troisième couche transparente 10 étant formées par traitement d'au moins un composant précurseur CP. En d'autres termes, la glace de fermeture 4 comprend une première couche transparente 6 présentant une face externe, cette dernière étant recouverte par la deuxième couche transparente 8 ou la troisième couche transparente 10, la couche transparente 8, 10 recouvrant la première couche transparente 6 étant également recouverte par l'autre couche transparente 8, 10.

On comprend de ce qui précède que la deuxième couche transparente 8 ou la troisième couche transparente 10 est disposée sur une face extérieure de la première couche transparente 6, c'est-à-dire vers l'environnement extérieur de la glace de fermeture 4. De plus, l'une ou l'autre des deuxième ou troisième couches transparentes 8, 10 est disposée entre l'autre couche transparente 8, 10 et la première couche transparente 6.

Selon un exemple de réalisation illustré ici sur la figure 2, la deuxième couche transparente 8 est disposée entre la première couche transparente 6 et la troisième couche transparente 10. Autrement dit, la deuxième couche transparente 8 est en contact direct avec la première couche transparente 6 d'une part et la troisième couche transparente 10 d'autre part. Cependant, une glace de fermeture 4 dont la troisième couche transparente 10 est disposée entre la première couche transparente 6 et la deuxième couche transparente 8 ne sortirait pas du cadre de l'invention.

Selon l'invention, le traitement d'au moins l'une des deuxième couche transparente 8 et/ou troisième couche transparente 10 est assistée par plasma atmosphérique à torche plasma. Sur l'exemple illustré ici, c'est la deuxième couche transparente 8 qui est réalisée par plasma atmosphérique à torche plasma. Cependant, une glace de fermeture 4 dont seulement la troisième couche transparente 10 serait réalisée par plasma atmosphérique à torche plasma ne sortirait pas du cadre de l'invention.

La troisième couche transparente 10 est ici réalisée par plasma atmosphérique à barrière diélectrique volumique. En d'autres termes, le traitement de la troisième couche transparente 10 est une polymérisation de l'au moins un composant précurseur CP assistée par plasma atmosphérique à décharge à barrière diélectrique volumique, ce dernier pouvant être une décharge électrique silencieuse ou une décharge lumineuse homogène.

Selon un mode de réalisation alternatif, la deuxième couche transparente 8 comprend plusieurs sous-couches en recouvrement les unes des autres formées par traitement d'au moins un composant précurseur CP par plasma atmosphérique à torche plasma, la troisième couche transparente 10 comprenant plusieurs sous-couches en recouvrement les unes des autres formées par traitement d'au moins un composant précurseur CP par plasma atmosphérique à décharge à barrière diélectrique volumique.

Il est avantageux que les couches, et/ou sous-couches dans l'exemple qui vient d'être évoqué, réalisées par plasma atmosphérique à torche plasma soient disposées plus proche de la première couche transparente 6 que de l'extérieur du dispositif lumineux 2, tandis que les couches, et/ou sous-couches éventuelles, réalisées par plasma atmosphérique à décharge à barrière diélectrique volumique soient disposées vers l'extérieur du dispositif lumineux 2, c'est-à-dire en recouvrement de la première couche transparente 6 et/ou des couches et/ou sous-couches réalisées par plasma atmosphérique à torche plasma. Tel que cela a pu être évoqué précédemment, un tel agencement permet de n'utiliser la technique à barrière diélectrique volumique, grâce à laquelle il est plus facile de contrôler les propriétés du polymère ainsi obtenu et donc les propriétés de la glace de fermeture, que pour la réalisation d'une couche destinée à être au contact de l'environnement extérieur et qui nécessite un traitement ciblé et destinée à être visible par les observateurs extérieurs et qui nécessite un design particulier.

Une description plus détaillée de chacun du procédé de réalisation de couche transparente par plasma atmosphérique à torche plasma sera réalisée plus tard dans la description.

La deuxième couche transparente 8 présente une épaisseur E d'au plus vingt nanomètres. Avantageusement, l'épaisseur E de la deuxième couche transparente 8 est comprise entre cinq et quinze nanomètres, et encore plus avantageusement, ladite épaisseur E est de dix nanomètres. L'épaisseur E de la deuxième couche transparente 8 est mesurée le long d'une direction perpendiculaire au plan d'extension principale de ladite couche entre une face interne et une face externe de ladite couche transparente.

La troisième couche transparente 10 présente quant à elle une épaisseur F d'au plus vingt-cinq nanomètres. Avantageusement, l'épaisseur F de la troisième couche transparente 10 est comprise entre dix et vingt nanomètres, et encore plus avantageusement, ladite épaisseur F est de quinze nanomètres. L'épaisseur F de la troisième couche transparente 10 est mesurée le long d'une direction perpendiculaire au plan d'extension principale de ladite couche entre une face interne et une face externe de ladite couche transparente.

La deuxième couche transparente 8 et/ou une troisième couche transparente 10 peut présenter des propriétés anti-corrosion, c'est-à-dire qu'elle protège la première couche transparente 6 de l'érosion provoquée par un composant dont les propriétés acido-basiques entraîneraient une incompatibilité avec les composants de la première couche transparente 6, provoquant une dégradation prématurée de ladite première couche transparente 6. De telles propriétés sont particulièrement avantageuses dans le cas d'application de la présente invention où la glace de fermeture est exposée à l'environnement extérieur. D'autres propriétés, par exemple hydrophiles ou hydrophobes, peuvent être appliquées à chacune des couches transparentes, et notamment celle destinée à être exposée à l'environnement extérieur, c'est-à-dire celle disposée à l'opposé de la première couche transparente.

Ces différentes propriétés associées à la deuxième couche transparente 8 et/ou la troisième couche transparente 10 leurs sont attribuées par les composants précurseurs CP incorporés dans le plasma utilisé pour réaliser ladite deuxième couche transparente 8 et/ou troisième couche transparente 10.

Le composant précurseur CP se présente sous forme gazeuse, pur ou en étant mélangé à un autre gaz. Selon un mode de réalisation alternatif, le composant précurseur CP se présente sous forme liquide, et/ou est dissous dans un solvant, et/ou est dilué dans solvant. La forme sous laquelle se présente le composant précurseur CP est notamment choisie en fonction du procédé utilisé pour réaliser la couche transparente. Ainsi, le composant précurseur CP se présente sous forme gazeuse lorsqu'il est utilisé pour réaliser une couche transparente par plasma atmosphérique à torche plasma tandis qu'il se présente sous forme liquide lorsqu'il est utilisé pour réaliser une couche transparente par plasma atmosphérique à décharge à barrière diélectrique volumique.

Avantageusement, au moins l'un des composants précurseurs CP utilisé pour réaliser la deuxième couche transparente 8 et/ou la troisième couche transparente 10 est choisi parmi un monomère organique, un monomère organométallique, un prépolymère organique et un de leurs mélange.

A titre d'exemples, le composant précurseur CP peut être choisi parmi l'acide acrylique, l'alcool polyvinylique, l'acétate d'éthyle, le perfluorodécyltriéthylsilane, le fluorométhacrylate, le bis(triéthoxysilyl)éthane, l'hexaméthyldisilazane (HMDSN), l'hexaméthyldisiloxane (HMDSO), l'octaméthylcyclotétrasiloxane (OMCTSO), le polydiméthylsiloxane (PDMS), le tétraéthyl orthosilicate (TEOS), l'isopropoxyde de titane (TIPP), l'aminopropyltriéthoxysilane (APTES), l'acéthylène, le méthane, le tétraglyme (tetraethylene glycol dimethyl ether), l'aminopropyltriéthoxysilane, l'hydroxyéthylméthacrylate, le polyéthylène glycol.

Par ailleurs, le matériau de la première couche transparente 6 comprend avantageusement au moins un polymère choisi parmi le polycarbonate (PC), le polycarbonate modifié haute température (PC-HT), le polyméthacrylate de méthyle (PMMA), le poly metacryl méthyl imide (PMMI), le cyclo olefine polymer (COP), le cyclo olefine copolymer (COC), le polysulfone (PSU), le polyarylate (PAR), le polyamide (PA), et un de leurs mélanges.

Tel qu'illustré sur la figure 2, la glace de fermeture 4 peut comprendre une couche préalable 12 formée au moins par un composant couplé à de l'argon, la couche préalable 12 étant disposée entre la première couche et la deuxième couche transparente 8 en étant réalisée par plasma atmosphérique à torche plasma ou à décharge à barrière diélectrique volumique. Avantageusement, cette couche préalable 12 est réalisée par plasma atmosphérique à torche plasma.

Cette couche préalable 12, dont la présence n'est pas obligatoire pour l'invention contrairement à la présence des première, deuxième et troisième couches transparentes précédemment évoquées, permet d'optimiser la fixation de la deuxième couche transparente 8 et/ou de la troisième couche transparente 10 sur la première couche transparente 6. Cette couche préalable 12 est également transparente et optiquement neutre.

De manière alternative ou complémentaire, la glace de fermeture 4 peut comprendre une couche externe 14 formée au moins par un précurseur additionnel et qui vient recouvrir le reste des couches pour être au contact de l'environnement extérieur. Tel qu'illustré sur la figure 2, la troisième couche transparente 10 est alors disposée entre la deuxième couche transparente 8 et la couche externe 14. Cette couche externe 14 est réalisée par plasma atmosphérique à décharge à barrière diélectrique volumique. On comprend que le précurseur additionnel de cette couche externe 14 est polymérisé afin d'obtenir un polymère organique présentant un degré de polymérisation voulu. Cette couche externe 14 peut présenter notamment des propriétés liées à la protection des différentes couches, comme des propriétés anti-abrasion, anti-corrosion et/ou encore hydrophobe pour limiter le dépôt d'eau et de buée sur la glace de fermeture 4.

On va maintenant décrire plus en détail le procédé de réalisation de la deuxième couche transparente 8 et de la troisième couche transparente 10 avant de décrire un procédé de traitement de la glace de fermeture 4.

Dans l'exemple illustré, avec la deuxième couche transparente 8 interposée entre la première couche transparente 6 et la troisième couche transparente 10, la deuxième couche transparente 8 est réalisée par plasma atmosphérique à torche plasma, c'est-à-dire par la formation d'un plasma à partir d'au moins un composant précurseur CP sous forme gazeuse disposé entre une électrode 20 et une contre-électrode 22.

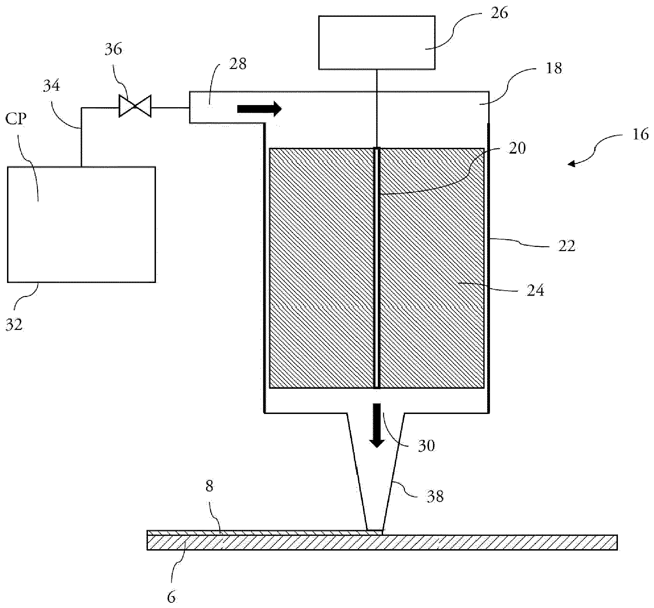

Plus particulièrement, et tel qu'illustré sur la figure 3, un tel procédé est mis en œuvre grâce à un premier dispositif de dépôt 16 dont la fonction est de fabriquer et déposer au moins la deuxième couche transparente 8 sur au moins la première couche transparente 6. Pour cela, le premier dispositif de dépôt 16 comprend au moins un corps à plasma 18, une électrode 20 et une contre-électrode 22.

Plus précisément, la contre-électrode 22 est par exemple formée par une bobine électromagnétique s'étendant dans le corps à plasma 18 en prenant la forme d'une torche, c'est-à-dire un conduit au centre duquel s'étend l'électrode 20. Dans cette configuration, la contre-électrode 22 et l'électrode 20 participent à délimiter un espace d'ionisation 24 au sein du corps à plasma 18 dans lequel le composant précurseur CP est ionisé sous forme de plasma.

Pour cela, l'électrode 20 est reliée électriquement à un générateur 26, ce dernier alimentant en électricité l'électrode 20. Le générateur 26 peut par exemple alimenter l'électrode 20 selon un voltage compris entre 60 et 100 volts, de sorte qu'un arc électrique soit produit entre l'électrode 20 et la contre-électrode 22 entraînant une ionisation du gaz s'étendant dans l'espace d'ionisation 24, c'est-à-dire entre ladite électrode 20 et ladite contre-électrode 22.

Le corps à plasma 18 comprend une entrée de gaz 28 et une sortie de plasma 30. L'entrée de gaz 28 est avantageusement reliée fluidiquement à un réservoir 32 en gaz, le gaz comprenant au moins l'un des composants précurseurs CP précités, la sortie de plasma 30 étant disposée ici à une extrémité du premier dispositif de dépôt 16. On comprend que, lors du fonctionnement du premier dispositif de dépôt 16, le gaz précurseur du plasma est introduit dans le corps à plasma 18 au travers de l'entrée de gaz 28, puis le gaz est ionisé dans l'espace d'ionisation 24 pour former un plasma qui est ensuite projeté vers l'extérieur du premier dispositif de dépôt 16 via la sortie de plasma 30.

Le corps à plasma 18 est relié au réservoir 32 par une canalisation 34 sur laquelle est installée une vanne de contrôle du débit 36, qui contrôle le débit de gaz circulant vers l'entrée de gaz 28 du corps à plasma 18 depuis le réservoir 32 de gaz.

La sortie de plasma 30 est quant à elle ouverte sur l'environnement extérieur du premier dispositif de dépôt 16, c'est-à-dire que l'air présent dans l'atmosphère est libre de circulation au travers du corps à plasma 18 au moins entre l'électrode 20 et la contre-électrode 22. On comprend ici que le gaz provenant du réservoir 32 se mélange dans le corps à plasma 18 avec l'air provenant du milieu extérieur au premier dispositif de dépôt 16, le plasma résultant dès lors de l'ionisation de ce mélange.

Une fois formé, le plasma est projeté à travers la sortie de plasma 30 contre la surface où doit être déposée la couche transparente, le plasma prenant avantageusement la forme d'un faisceau 38. On comprend qu'au contact de ladite surface, ici la première couche transparente 6, le plasma se solidifie et forme la deuxième couche transparente 8. Le premier dispositif de dépôt 16 est ensuite déplacé le long de la première couche transparente 6 de sorte à déposer la deuxième couche transparente 8 en recouvrement de ladite première couche transparente 6.

Dans l'exemple illustré, la troisième couche transparente 10 est quant à elle réalisée par plasma atmosphérique à décharge à barrière diélectrique volumique, c'est-à-dire par la formation d'un plasma à partir d'au moins un composant précurseur CP sous forme liquide, le plasma se polymérisant pour former ladite troisième couche transparente 10. Avantageusement, la troisième couche transparente 10 est réalisée par plasma atmosphérique à décharge électrique silencieuse. Un tel procédé est mis en œuvre grâce à un deuxième dispositif de dépôt, non représenté sur l'ensemble des figures, dont la fonction est de fabriquer par polymérisation d'au moins l'un des composants précurseurs CP, et déposer au moins la troisième couche transparente 10 sur au moins la deuxième couche transparente 8.

On va maintenant décrire plus en détail le procédé de traitement de la glace de fermeture 4, ce dernier mettant notamment en œuvre les procédés de réalisation de la deuxième couche transparente 8 et de la troisième couche transparente 10.

Le procédé de traitement de la glace de fermeture 4 transparente comprend une première étape de traitement au cours de laquelle la deuxième couche transparente 8 est formée en recouvrement de la première couche transparente 6 et au moins une deuxième étape de traitement au cours de laquelle la troisième couche transparente 10 est réalisée en recouvrement de la deuxième couche transparente 8, au moins l'une des étapes de traitement étant réalisée par plasma atmosphérique à torche plasma. On comprend ici que la deuxième couche transparente 8 et la troisième couche transparente 10 sont réalisées l'une après l'autre.

Tel qu'évoqué précédemment, dans l'exemple illustré, la deuxième couche transparente 8 est réalisée par plasma atmosphérique à torche plasma au cours de la première étape de traitement tandis que, au cours de la deuxième étape de traitement, la troisième couche transparente 10 est réalisée par plasma atmosphérique à décharge à barrière diélectrique volumique.

Dans l'exemple précédemment évoqué où la glace de fermeture comprend la couche préalable 12, le procédé de traitement de la glace de fermeture 4 comprend également une étape préalable à l'une ou l'autre des étapes de traitement au cours de laquelle un composant couplé à de l'argon est déposée sur la première couche en étant réalisée par plasma atmosphérique à torche plasma ou à décharge à barrière diélectrique volumique. On comprend que l'étape préalable est réalisée en amont de la première étape de traitement et de la deuxième étape de traitement. La couche préalable 12 permet, une fois disposée contre la première couche transparente 6, de créer une meilleure accroche de l'une ou l'autre des couches transparentes 8, 10.

Par ailleurs, dans l'exemple précédemment évoqué où la glace de fermeture comprend la couche externe 14, le procédé de traitement de la glace de fermeture 4 comprend également une étape de protection de la glace de fermeture 4 au cours de laquelle la couche externe 14 est réalisée par un précurseur additionnel par plasma atmosphérique à décharge à barrière diélectrique volumique. On comprend que l'étape de protection est réalisée après les première et deuxième étapes de traitement, la couche externe 14 étant disposée en recouvrement de la deuxième couche transparente 8 et de la troisième couche transparente 10.

On comprend de ce qui précède, qu'avantageusement, le procédé de traitement de la glace de fermeture 4 comprend successivement l'étape préalable, la première étape de traitement, la deuxième étape de traitement et l'étape de protection. Cependant, un procédé de traitement ne comprenant que la première étape de traitement et la deuxième étape de traitement, avec ou non l'étape préalable et/ou l'étape de protection, ne sortirait pas du cadre de l'invention.

La présente invention ne saurait toutefois se limiter aux moyens et configurations décrits et illustrés ici et elle s'étend également à tout moyen et configuration équivalents ainsi qu'à toute combinaison techniquement opérante de tels moyens.

## Revendications

1. Glace de fermeture (4) d'un dispositif lumineux (2) ou d'un élément de détection pour véhicule (1) comprenant au moins une première couche transparente (6) en un matériau polymère, **caractérisée en ce que** la glace de fermeture (4) comprend au moins une deuxième couche transparente (8) et une troisième couche transparente (10) formées par traitement d'au moins un composant précurseur (CP), les couches étant réalisées en recouvrement les unes des autres, le traitement étant :
a. soit assisté par plasma atmosphérique à torche plasma pour au moins l'une des deuxième couche transparente (8) et/ou troisième couche transparente (10) ;
b. soit assisté par plasma atmosphérique à torche plasma pour la deuxième couche transparente (8) et une polymérisation de l'au moins un composant précurseur (CP) assistée par plasma atmosphérique à décharge à barrière diélectrique volumique pour la troisième couche transparente (10).

2. Glace de fermeture (4) selon la revendication précédente, dans laquelle la deuxième couche transparente (8) présente une épaisseur (E) d'au plus vingt nanomètres.

3. Glace de fermeture (4) selon l'une quelconque des revendications précédentes, dans laquelle la deuxième couche transparente (8) est disposée entre la première couche transparente (6) et la troisième couche transparente (10).

4. Glace de fermeture (4) l'une quelconque des revendications précédentes prise selon la seconde alternative de la revendication 1, dans laquelle la deuxième couche transparente (8) comprend plusieurs sous-couches en recouvrement les unes des autres formées par traitement d'au moins un composant précurseur (CP) par plasma atmosphérique à torche plasma, la troisième couche transparente (10) comprenant plusieurs sous-couches en recouvrement les unes des autres formées par traitement d'au moins un composant précurseur (CP) par plasma atmosphérique à décharge à barrière diélectrique volumique.

5. Glace de fermeture (4) selon l'une quelconque des revendications précédentes, comprenant une couche préalable (12) formée au moins par un composant couplé à de l'argon, la couche préalable (12) étant disposée entre la première couche et la deuxième couche transparente (8) en étant réalisée par plasma atmosphérique à torche plasma ou à décharge à barrière diélectrique volumique.

6. Glace de fermeture (4) selon l'une quelconque des revendications précédentes, comprenant une couche externe (14) formée au moins par un précurseur additionnel, la troisième couche transparente (10) étant disposée entre la deuxième couche transparente (8) et la couche externe (14), la couche externe (14) étant réalisée par plasma atmosphérique à décharge à barrière diélectrique volumique.

7. Glace de fermeture (4) selon l'une quelconque des revendications précédentes, dans laquelle le composant précurseur (CP) est choisi parmi un monomère organique, un monomère organométallique, un prépolymère organique et un de leurs mélanges.

8. Glace de fermeture (4) selon l'une quelconque des revendications précédentes, dans laquelle le matériau polymère de la première couche transparente (6) comprend au moins un polymère choisi parmi le polycarbonate (PC), le polycarbonate modifié haute température (PC-HT), le polyméthacrylate de méthyle (PMMA), le poly metacryl méthyl imide (PMMI), le cyclo olefine polymer (COP), le cyclo olefine copolymer (COC), le polysulfone (PSU), le polyarylate (PAR), le polyamide (PA), et un de leurs mélanges.

9. Procédé de traitement d'une glace de fermeture (4) transparente selon l'une quelconque des revendications précédentes, procédé comprenant une première étape de traitement au cours de laquelle la deuxième couche transparente (8) est formée sur la première couche transparente (6) et au moins une deuxième étape de traitement au cours de laquelle la troisième couche transparente (10) est réalisée sur la deuxième couche transparente (8), **caractérisé en ce qu'**au moins l'une des étapes de traitement est réalisée par plasma atmosphérique à torche plasma.

10. Procédé de traitement d'une glace de fermeture (4) transparente selon la revendication 4, procédé comprenant une première étape de traitement au cours de laquelle la deuxième couche transparente (8) est formée sur la première couche transparente (6) et au moins une deuxième étape de traitement au cours de laquelle la troisième couche transparente (10) est réalisée sur la deuxième couche transparente (8), **caractérisé en ce que**, au cours de la première étape de traitement, la deuxième couche transparente (8) est réalisée par plasma atmosphérique à torche plasma tandis que, au cours de la deuxième étape de traitement, la troisième couche transparente (10) est réalisée par plasma atmosphérique à décharge à barrière diélectrique volumique.
